(19) Europäisches Patentamt
European Patent Office
Office européen des brevets

(11) EP 2 996 834 B1

(12) **EUROPÄISCHE PATENTSCHRIFT**

(45) Veröffentlichungstag und Bekanntmachung des Hinweises auf die Patenterteilung:
**17.10.2018 Patentblatt 2018/42**

(21) Anmeldenummer: **14723424.9**

(22) Anmeldetag: **12.05.2014**

(51) Int Cl.:
*B23K 20/10* (2006.01)          *B29C 65/08* (2006.01)
*B29C 65/00* (2006.01)          *H01L 23/00* (2006.01)
*H01R 43/02* (2006.01)

(86) Internationale Anmeldenummer:
**PCT/EP2014/059589**

(87) Internationale Veröffentlichungsnummer:
**WO 2014/198467 (18.12.2014 Gazette 2014/51)**

(54) **VERFAHREN ZUM ERMITTELN DES VERDICHTUNGSGRADES EINES KNOTENS NACH DEM ULTRASCHALL-SCHWEISSEN**

METHOD FOR DETERMINING THE COMPRESSION LEVEL OF A NODE AFTER ULTRASONIC WELDING

PROCÉDÉ POUR DÉTERMINER LE DEGRÉ DE COMPRESSION D'UN NOEUD APRÈS SOUDAGE PAR ULTRASONS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **13.05.2013 DE 102013104895**
**18.06.2013 DE 102013106349**

(43) Veröffentlichungstag der Anmeldung:
**23.03.2016 Patentblatt 2016/12**

(73) Patentinhaber: **Schunk Sonosystems GmbH**
**35435 Wettenberg (DE)**

(72) Erfinder: **STROH, Dieter**
**35435 Wettenberg (DE)**

(74) Vertreter: **Stoffregen, Hans-Herbert**
**Patentanwalt**
**Friedrich-Ebert-Anlage 11b**
**63450 Hanau (DE)**

(56) Entgegenhaltungen:
**DE-A1- 4 429 684     DE-C1- 4 335 108**

**Beschreibung**

Die Erfindung bezieht sich auf ein Verfahren zur Ermittlung des Verdichtungsgrades eines Knotens durch Kompaktieren und Schweißen von in einen in Höhe und Breite verstellbaren Verdichtungsraum einer Ultraschallschweißanlage eingelegten elektrischen Leitungen bekannten Gesamtnominalquerschnitts $A_{nom}$, die aus Adern mit einem tatsächlichen Gesamtquerschnitt $A_{tats}$ bestehen, wobei der Verdichtungsraum zumindest von einer Sonotrode, einer Gegenelektrode oder einem Amboss und einem eine begrenzende Fläche aufweisenden Seitenschieber begrenzt wird (siehe z.B. DE 44 29 684 A1).

Ein Verfahren zum Kompaktieren und anschließenden Verschweißen von elektrischen Leitern, insbesondere zur Herstellung von Durchgangs- oder Endknoten von Litzen mittels Ultraschall in einem an die Leiter anpassbaren Verdichtungsraum ist aus der EP 701 876 A1 bekannt.

Zum Kompaktieren und anschließenden Verschweißen von elektrischen Leitern, insbesondere zur Herstellung von Durchgangs- und Endknoten von Litzen, werden Ultraschallschweißvorrichtungen eingesetzt, die Sonotroden für die Erzeugung von Ultraschallschwingungen aufweisen. Ein Abschnitt der jeweiligen Sonotrode bildet eine erste seitliche Begrenzungsfläche eines z. B. in Höhe und Breite verstellbaren, stirnseitig offenen Verdichtungsraums. Die anderen Begrenzungsflächen des Verdichtungsraums können Abschnitte einer mehrteiligen Gegenelektrode sowie eines Seitenschiebers sein. Beispiele für Ultraschallschweißvorrichtungen sind unter den Bezeichnungen GS-40/50 oder Minic II der Schunk Sonosystems GmbH, Wettenberg, Bundesrepublik Deutschland, angebotene Geräte.

Aus der DE 43 35 108 C1 sind ein Verfahren und eine Vorrichtung zum Kompaktieren und anschließenden Verschweißen von Leitern, insbesondere zur Herstellung von Durchgangs- oder Endknoten von Litzen, mittels Ultraschall in einem an die Leiter angepassten, in Höhe und Breite verstellbaren Verdichtungsraum, wobei die zu verschweißenden Leiter zunächst kompaktiert und sodann verschweißt werden, bekannt. Dabei ist der Verdichtungsraum unabhängig vom Querschnitt der zu verschweißenden Leiter in ein vorgegebenes Höhen-Breiten-Verhältnis einstellbar.

Aus der WO 91/09704 A1 ist ein Verfahren zum Verschweißen von Anschlusskabeln für Transformatoren bekannt. Um eine sichere Verbindung mittels Ultraschall zu erzielen, werden die zu verbindenden Kabelenden angefast.

Aus der EP 0 421 018 A1 sind ein Verfahren und eine Vorrichtung zum Schweißen von metallischen Werkstücken durch Ultraschall zu entnehmen. Zur Qualitätssicherung der Schweißergebnisse ist vorgesehen, dass die Absenkgeschwindigkeit einer Sonotrode in Abhängigkeit von Abmessungen bzw. Ausbildung der zu verschweißenden Werkstücke bzw. deren Beschichtung gesteuert wird.

Um den heutigen Anforderungen zu genügen, muss sichergestellt sein, dass Materialänderungen bzw. ein Wechsel von die Ultraschallschweißvorrichtung bedienenden Personen einen Einfluss auf die verschweißten Endprodukte nicht zeigen.

Nach dem Stand der Technik werden z. B. Cu- oder Al-Leitungen entsprechend einer Norm mit einem Nominalquerschnitt, wie beispielsweise 5 mm$^2$ gekennzeichnet. Diese Leitungen weisen jedoch bei gleicher Leitfähigkeit einen tatsächlichen Querschnitt von beispielsweise 4,3 mm$^2$ auf, der geringer ist als der Nominalquerschnitt.

Bei der Ultraschallschweißung von beispielsweise 4 Leitungen mit einem Nominalquerschnitt von 5 mm$^2$ würde ein Schweißknoten mit einem Gesamtnominalquerschnitt $A_{nom}$ von 4 x 5 mm$^2$ = 20 mm$^2$ erzeugt werden, der jedoch nicht mit dem tatsächlichen Gesamtquerschnitt $A_{tats}$ übereinstimmt.

Zur Überprüfung der Qualität eines Schweißknotens zählt nach dem Stand der Technik u.a. die Ermittlung eines sogenannten Verdichtungsgrads V. Dabei werden Höhe und Breite des fertigen Schweißknotens gemessen und mit einem zuvor aus den einzelnen Leitungen manuell ermittelten tatsächlichen Querschnitt nach einer der Formeln

a) $V = [A_{tats} / b \cdot (h - PK)] \cdot 100$ in %
oder
b) $V = [b \cdot h / A_{tats}] \cdot 100$ in %

in Beziehung gesetzt.

Dabei ist $A_{tats}$ der tatsächliche Querschnitt der Leitungen, also deren Adern, b = Breite und h = Höhe des Verdichtungsraums nach dem Schweißen.

Die Überprüfung des Verdichtungsgrades des Schweißknotens erfolgt außerhalb des Verdichtungsraums und ist mit hohem Zeit- und Kostenaufwand verbunden.

Davon ausgehend liegt der vorliegenden Erfindung die Aufgabe zugrunde, ein Verfahren der eingangs genannten Art so weiterzubilden, dass die Verdichtungsgradermittlung vereinfacht wird.

Ein Verfahren zur Ermittlung des Verdichtungsgrades V eines Knotens gemäß der Erfindung ist in dem Anspruch 1 definiert, mit folgenden Schritten:

- Einlegen der Leitungen in den Verdichtungsraum,
- Kompaktieren der Leitungen unter Zugrundelegung des Gesamtnominalquerschnitts $A_{nom}$.
- Ermitteln des Kompaktierquerschnitts A der kompaktierten Leitungen,

    - Ermitteln des tatsächlichen Gesamtquerschnitts $A_{tats}$ über eine den Kompaktierquerschnitt A berücksichtigende Korrelationsfunktion mit $A_{tats}$ = A : K. wobei K ein aus der Korrelationsfunktion in Abhängigkeit von dem Gesamtnominalquerschnitt ermittelter Korrekturwert ist,

- Schweißen des kompaktierten Knotens mit einem
  Schweißparametersatz für den Gesamtnominalquerschnitt $A_{nom}$ oder den tatsächlichen Gesamtquerschnitt $A_{tats}$,
- Ermitteln eines Schweißmaßes aus Höhe und Breite
  des Verdichtungsraums nach dem Schweißen,

  - Berechnung des Verdichtungsgrades unter Zu-
    grundelegung des tatsächlichen Gesamtquer-
    schnitts $A_{tats}$ und des Schweißmaßes unter Berücksichtigung einer der Gleichungen

    a) $V = [A_{tats}/ b \cdot (h - PK)] \cdot 100$ in %
    b) $V = [b \cdot h / A_{tats}] \cdot 100$ in %,

    wobei PK Geometrie bzw. Profilierung der den
    Verdichtungsraum begrenzenden Flächen der
    Sonotrode und der Gegenelektrode berücksichtigt.

Betreffend die Korrelationsfunktion ist anzumerken, dass es sich dabei um eine ermittelte Korrelation
für definierte Leitungstypen und Werkzeugprofilgeometrien handelt. Die Leitungstypen können z.B. FLRY Typ
A oder Typ B sein, d. h., Leitungen gleichen Nominalquerschnitts mit unterschiedlichem Aderaufbau, d.h.,
verschiedene Adern- bzw. Litzenanzahl und Adern- bzw.
Litzendurchmesser. Für einen Querschnitt von z. B. 0,5
mm² weist Leitung Typ A neunzehn Adern mit jeweiligem
Durchmesser von 0,19 mm und Leitung Typ B sechzehn
Adern mit Durchmessern von jeweils 0,21 mm auf.
Ganz allgemein wird die Korrelationsfunktion
dadurch ermittelt, dass zuvor Leitungen mit voneinander
abweichenden zuvor ermittelten tatsächlichen Gesamtquerschnitten kompaktiert werden und der Quotient von
jedem tatsächlichen Gesamtquerschnitt und ermittelten
zugehörigem Kompaktierquerschnitt gebildet wird und
dass die Korrelationsfunktion durch Auftragen des Quotienten gegenüber dem den tatsächlichen Gesamtquerschnitten zugeordneten Nominalquerschnitten gebildet
wird. Die Korrelationsfunktion, die in der Ultraschallschweißanlage bzw. in deren Rechner bzw. Steuereinheit abgelegt wird, kann zuvor zum Beispiel an einer Basismaschine ermittelt und sodann in entsprechende Ultraschallschweißanlagen implementiert werden. Es besteht jedoch auch die Möglichkeit, dass mit jeder zum
Einsatz gelangenden Maschine ein "Anlernen" über das
Kompaktieren von Leitungen unterschiedlicher Gesamtnominalquerschnitte und zugehörigen tatsächlichen Gesamtquerschnitten und Ermitteln zugehöriger tatsächlicher Kompaktierquerschnitte erfolgt. Auf der Basis der
Messergebnisse wird sodann die Korrelationsfunktion
ermittelt und in der Ultraschallschweißanlage abgelegt.
Die Erfindung zeichnet sich gegenüber dem
Stand der Technik dadurch aus, dass der tatsächliche

Gesamtquerschnitt $A_{tats}$ und der Verdichtungsgrad online errechnet wird, wobei einzig und allein der Nominalquerschnitt der zu einem Knoten zu verschweißenden
Leitungen und ggfs. die Werkzeuggeometrie bzw. deren
Profilierung bekannt sein muss, sofern bei der Berechnung des Verdichtungsgrads letztere eingeht.
Zur Berechnung des Verdichtungsgrads V wird
auf bekannte gängige Formeln mit oder ohne Profilkorrektur PK zurückgegriffen, die beispielsweise in Automobilindustrie vorgegeben werden.
Profilkorrektur PK bedeutet dabei, dass die Geometrie von Sonotrode und Gegenelektrode, also Amboss, soweit diese den Verdichtungsraum begrenzen,
bei der Berechnung mit eingeht.
Als Formeln zur Berechnung des Verdichtungsgrads V können verwendet werden:

    a) $V = [A_{tats}/ (b \cdot (h - PK)] \cdot 100$ in %
    oder
    b) $V = [b \cdot h/ A_{tats}] \cdot 100$ in %

mit h = Höhe und b = Breite des Verdichtungsraums nach
dem Schweißen des Knotens ist.
Die Ergebnisse aus a), b) sind nicht direkt vergleichbar, d.h., es gelten unterschiedliche Zielwerte. Die
bei der Erfindung bevorzugte Formel ist die Formal a).
Die Profilkorrektur PK liegt vorzugsweise im Bereich $0,1 \leq PK \leq 0,5$, vorzugsweise PK=0,2.
Weitere Einzelheiten, Vorteile und Merkmale
der Erfindung ergeben sich nicht nur aus den Ansprüchen, den diesen zu entnehmenden Merkmalen -für sich
und/oder in Kombination-, sondern auch aus der nachfolgenden Beschreibung eines der Zeichnung zu entnehmenden bevorzugten Ausführungsbeispiels.
Es zeigen:

Fig. 1       eine Prinzipdarstellung einer Ultraschallschweißanlage,

Fig. 2       einen Ausschnitt einer Ultraschallschweißvorrichtung mit veränderbarem
      Verdichtungsraum,

Fig. 3a) - d)       Leitungen unterschiedlichen Aufbaus,

Fig. 4 und 5       Verfahrensschritte zum Kompaktieren
      von Leitungen,

Fig. 6       eine Korrelationsfunktion,

Fig. 7       Prinzipdarstellungen des Verfahrensschritts des Schweißens und

Fig. 8       einen Schnitt entlang der Linie A-A in Fig.
      7.

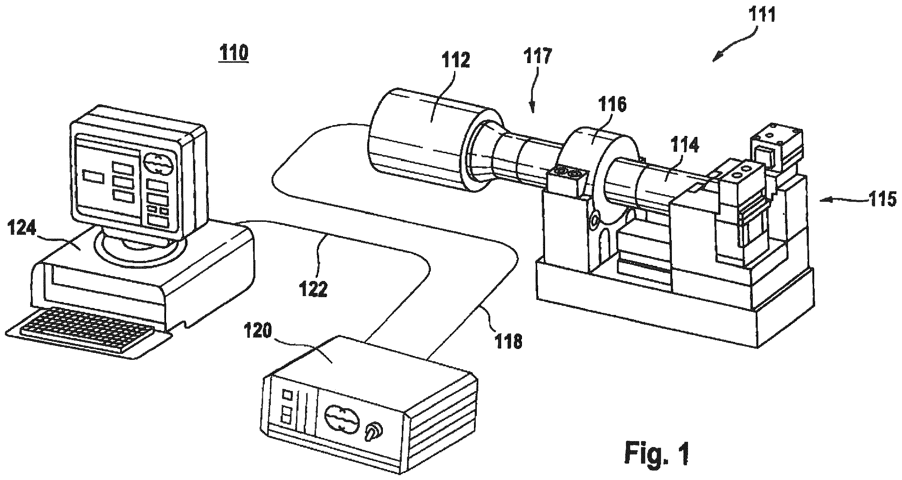

In Fig. 1 ist rein prinzipiell eine Ultraschallschweißanlage 110 dargestellt, anhand der die wesentlichen Elemente erläutert werden, um elektrische Leitungen zu einem End- oder Durchgangsknoten zu verschweißen.

Die Ultraschallschweißanlage 110 umfasst als wesentliche Elemente einen Konverter 112 und eine Sonotrode 114, zwischen denen ein Booster 116 zur Amplitudenverstärkung angeordnet ist. Konverter 112, Booster 116 und Sonotrode 114 bilden einen sogenannten Ultraschallschwinger 117, der im Booster 116 gelagert ist. Der Sonotrode 114, d.h., deren in Fig. 1 nicht erkennbarer Kopf ist eine Gegenelektrode 115 zugeordnet. Die Gegenelektrode 115 ist absenkbar, um Kräfte beim Schweißen auf die Fügepartner, also Leitungen, einzuleiten. Ferner sind Seitenschieber vorhanden, um einen von Sonotrode 114, Gegenelektrode oder Amboss 115 und Seitenschieber umgebenen Verdichtungsraum in gewünschtem Umfang in Höhe und Breite verstellen zu können.

Der Konverter 112 ist über eine Leitung 118 mit einem Generator 120 verbunden, der seinerseits über eine Leitung 122 an einem Rechner 124 angeschlossen ist. Über den Generator 120 wird der Konverter 112, d.h., die in diesem angeordneten Piezokeramikscheiben mit Hochfrequenzspannung beaufschlagt, um die Scheiben entsprechend zu dehnen bzw. zu kontrahieren, wodurch Ultraschallschwingungen mit einer Amplitude erzeugt werden, die vom Booster 116 verstärkt auf die Sonotrode 114 übertragen werden.

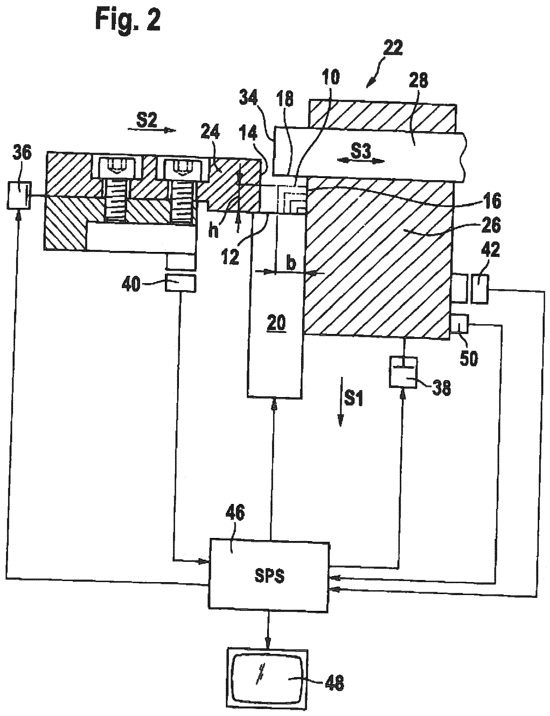

In Fig. 2 ist ein Ausschnitt einer Ultraschallschweißvorrichtung zum Verschweißen elektrischer Leitungen dargestellt, die einen auf die zu verschweißende Leitungen einstellbaren Verdichtungsraum 10 aufweist. Dabei kann die Ultraschallschweissvorrichtung selbst grundsätzlich einer Konstruktion entsprechen, die dem Gerät GS-40/50 oder Minic II der Schunk Sonosystems GmbH, Wettenberg, entspricht.

Der Verdichtungsraum 10 weist im Ausführungsbeispiel einen rechteckigen Querschnitt auf und ist stirnseitig offen, um durch diesen die zu verschweißenden Leitungen zu führen. Verdichtungsräume mit anderen Querschnitten sind selbstverständlich auch möglich, wie insbesondere mit einem trapezförmigen Querschnitt.

Der Verdichtungsraum 10 wird seitlich von Begrenzungsflächen 12, 14, 16 und 18 umschlossen, die Abschnitte einer Sonotrode 20, einer mehrteiligen Gegenelektrode 22 wie Amboss sowie eines Seitenschiebers 24 sind.

Der Schieber 24 ist entlang der Sonotrode 20 verschiebbar ist und bildet die seitliche Begrenzungsfläche 12. Die Bewegungsrichtung des Schiebers 24 ist durch den Pfeil S2 angedeutet. Die Gegenelektrode 22 ist in bekannter Weise zweiteilig ausgebildet und weist einen Träger 26 - auch Tuschierplatte genannt - auf, von dem ein in Richtung des Pfeils 53 verschiebbares Querhaupt 28 ausgeht, über das die erforderlichen Kräfte auf die im Verdichtungsraum 10 eingelegten Leitungen beim Kompaktieren und Verschweißen übertragen werden. Das Querhaupt 28 bildet die Begrenzungsfläche 18 und der Träger 26 die Begrenzungsfläche 16 des Verdichtungsraums 10. Die Fläche 18 des Querhaupts 28 verläuft parallel zu der von der Sonotrode 20 gebildeten Begrenzungsfläche 12.

Der von den Begrenzungsflächen 12, 14, 16 und 18 umschlossene Verdichtungsraum 10 wird in Abhängigkeit von den jeweils zu verschweißenden Leitungen verändert.

Der Verdichtungsraum 10 wird zum Kompaktieren der eingelegten Leitungen, also zum Vorverdichten, auf eine zuvor festgelegte Breite b eingestellt. Die Breite b des Verdichtungsraums 10 hängt dabei von dem Nominalquerschnitt der Leitungen ab, die zu einem Knoten verdichtet und verschweißt werden sollen.

Der Schieber 24 ist mit einem Antrieb 36, insbesondere einem pneumatischen oder hydraulischen Antrieb, verbunden, durch den der Schieber 24 in Richtung des Pfeils S2 und umgekehrt bewegbar ist. Der Träger 26 der Gegenelektrode 22 ist mit einem Antrieb 38 verbunden, der ebenfalls vorzugsweise als pneumatischer oder hydraulischer Antrieb ausgebildet sein kann.

Mittels des Antriebs 38 ist der Träger 26 in Richtung des Pfeils S1 und umgekehrt verschiebbar. Der Schieber 24 ist weiterhin mit einem Lagegeber 40 verbunden, mit dem die Stellung des Schiebers 24 in Bezug auf eine Ruhelage messbar ist. Auch der Träger 26 ist mit einem Lagegeber 42 verbunden, mit dem die Stellung des Trägers 26 in Bezug auf eine Ruhelage ermittelt werden kann.

Eine Steuereinrichtung 46, z. B. eine speicherprogrammierbare Steuerung, ist mit den Lagegebern 40, 42 der Ultraschall abgebenden Sonotrode 20 sowie mit nicht näher dargestellten Steuerelementen für die Antriebe 36, 38 verbunden. An der Steuereinrichtung 46 ist ein Monitor 48 angeschlossen.

Die Höhe h und/oder die Breite b des Verdichtungsraums 10 wird mittels von zumindest einem Lagegeber, im Ausführungsbeispiel von den Lagegebern 40, 42, generierter und von der Steuereinrichtung 46 ausgewerteter Messwerte bestimmt. Verschiedenen Querschnitten bzw. unterschiedlichen Höhen oder Breiten des Verdichtungsraums 10 sind verschiedene Parameter zugeordnet, die mit der Ultraschallschweißvorrichtung zum Kompaktieren bzw. Schweißen der Leitungen eingestellt werden. Es handelt sich um Kompaktier- bzw. Schweißparameter wie Energie, Amplitude, Druck- bzw. Schweißzeit.

Während des Schweißens wird insbesondere die Höhe h des Verdichtungsraums 10 verändert, wobei die Breite b gleich bleibt, da z. B. nach dem Abschluss einer auf die Leitungen ausgeübten Vorverdichtung der Schieber 24 arretiert wird.

Mit dem Träger 26 kann auch ein Kraftsensor 50 verbunden sein, mit dem die auf die in den Verdichtungsraum 10 eingelegten Leitungen mittels des Trägers 26 ausgeübte Kraft gemessen wird. Der Kraftsensor 50 ist ebenfalls an die Steuereinheit 46 angeschlossen. Selbstverständlich kann auch eine indirekte Messung durch Druckregelung erfolgen.

Mit der oben beschriebenen Vorrichtung werden die in den Verdichtungsraum 10 eingelegten Leitungen zunächst kompaktiert, indem der Schieber 24 so verstellt wird, dass die Breite des Verdichtungsraums 10 auf ein Maß, das von dem Gesamtnominalquerschnitt der Leitungen abhängig ist und im Rechner der Ultraschallschweißanlage als Parameter abgelegt ist, reduziert wird. Während des Kompaktierens wird sodann auch die Höhe h verändert. Kräfte für die Einstellung des Querschnitts werden von der Steuereinheit 46 über an die Antriebe 36, 38 ausgehende Signale ausgelöst, wobei der jeweils sich einstellende Querschnitt des Verdichtungsraums 10 mittels der von den Lagegebern 40, 42 erzeugten Messwerte von der Steuereinheit 46 bestimmt wird.

Der Querschnitt bzw. die Höhe h oder die Breite b des Verdichtungsraums 10 am Ende oder nach Beendigung der Vorverdichtung, also des Kompaktierens, ist demnach ein Maß für den Grad der Vorverdichtung, d. h. die Geometrie des Verdichtungsraums 10 kann als Kompaktiermaß verwendet bzw, ausgewertet werden. Da z. B. nur die Breite b und/oder die Höhe h des Verdichtungsraums 10 verändert wird, lässt sich der Querschnitt schnell und einfach automatisch bestimmen.

Wenn ein Kraftsensor 50 vorhanden ist, kann auch die auf die Leitungen ausgeübte Kraft als Kompaktiermaß verwendet werden.

Die einzustellende Breite b des Verdichtungsraums 10 beim Kompaktieren ist eine Funktion von dem Gesamtnominalquerschnitt der zu kompaktierenden Leitungen. Bei üblichen Kompaktier- und Schweißvorgängen liegt die Breite b zwischen 0,5 mm und 15 mm. Der beim Kompaktieren auf die Leitung einwirkende Druck liegt üblicherweise zwischen 1 bar und 6 bar. Während des Kompaktierens kann ein Ultraschallimpuls auf die Leitungen eingeleitet werden. Die Impulsdauer beläuft sich zwischen 50 ms und 200 ms. Die Amplitude sollte zwischen 15 $\mu$m und 20 $\mu$m bei einer Frequenz von 20 kHz liegen.

Während des Schweißvorgangs wird der Querschnitt - grundsätzlich nur die Höhe h der die Breite b - des Verdichtungsraums 10 erneut verändert, wobei der bei oder nach Beendigung des Schweißens vorhandene Querschnitt ein Maß für die Qualität der Schweißung der Leiter ist.

Da das Kompaktiermaß und das Schweißmaß mittels Stellgliedern wie des Schiebers 24 bzw. der Gegenelektrode 22 einstellbar sind, werden in die Steuereinheit 46 entsprechende Sollwerte eingegeben. Weiterhin werden in die Steuereinheit 46 feste obere und untere Grenzwerte für die Kompaktiermaße und Schweißmaße eingegeben. Diese Grenzwerte werden als äußere Grenzwerte bezeichnet. Weitere Grenzwerte, die im folgenden als innere Grenzwerte bezeichnet werden und die jeweils eine obere und eine untere Grenze für das Kompaktiermaß und/oder das Schweißmaß bei der Herstellung von verschweißten Leitern festlegen, werden mit der Steuereinheit 46 bestimmt.

Mit der oben beschriebenen Vorrichtung wird das folgende Verfahren ausgeübt.

In einem ersten Schritt wird die Ultraschallschweißvorrichtung in Gang gesetzt. Danach wird in einem ersten Schritt eine gewünschte Kombination von bekannten Leitungen in den Verdichtungsraum 10 eingelegt, der für den bekannten Gesamtnominalquerschnitt der Leitungen vom Rechner der Ultraschallschweißanlage vorgegeben wird. Anschließend wird der Kompaktierprozess gestartet. Somit wird der Verdichtungsraum 10 geschlossen, indem der Schieber 24 und die mehrteilige Gegenelektrode 22 in Richtung der Pfeile S2, S3 und S1 angetrieben bzw. bewegt werden.

Üblicherweise wird die Breite b des Verdichtungsraums 10 nicht verändert, so dass der Schieber 24 nicht bewegt wird. Folglich wird beim Kompaktieren allein die Höhe des Verdichtungsraums 10 verändert.

Während des Schließens des Verdichtungsraums 10 oder danach wird ein Ultraschallimpuls oder eine Folge davon erzeugt, um die Leitungen stärker zu kompaktieren. Hierdurch erfolgt im eigentlichen Sinne eine Vergleichmäßigung des Kompaktierens. Nach dem Kompaktieren wird in einem anschließenden Schritt das Kompaktiermaß, insbesondere die Kompaktierhöhe h aus der Geometrie des Verdichtungsraums 10, der durch die Kenntnis der Breite b und/oder Höhe h oder einer anderen spezifischen Größe bestimmt wird, ermittelt.

Nach dem Messen der Kompaktierhöhe h erfolgt in einem nächsten Schritt die Berechnung des tatsächlichen Leitungsgesamtquerschnitts $A_{TATS}$ über eine Korrelationsfunktion. Gemäß einer ersten Alternative handelt es sich dabei um eine ermittelte Korrelation für definierte Leitungstypen und Werkzeugprofilgeometrie. Leitungstypen sind z. B. FRLY Typ A oder Typ B, d. h., Leitungen gleichen Nominalquerschnitts mit unterschiedlichem Aderaufbau, d. h., verschiedene Litzenanzahl und Litzendurchmesser für einen Querschnitt. Z. B. hat eine 0,5 mm$^2$ Leitung Typ A neunzehn Adern mit einem Durchmesser von 0,19 mm, eine Leitung Typ B hat 1 sechzehn Adern mit einem Durchmesser von 0,21 mm.

Alternativ erfolgt ein "Anlernen" über Einlegen und Verdichten von bekannten/ ermittelten Ist-Querschnitten und Errechnen der Korrelationsfunktion.

Nach dem Errechnen des tatsächlichen Gesamtquerschnitts $A_{tats}$ über die Korrelationsfunktion erfolgt eine Abfrage, nämlich ob ein Schweißen mit einem Parametersatz für den Nominalquerschnitt oder mit einem Parametersatz für den tatsächlichen Gesamtquerschnitt erfolgen soll.

Nach Auswahl des entsprechenden Parametersatzes wird die Ultraschallschweißung durchgeführt.

Beim Schweißen bleibt die Breite b des Verdichtungsraums im Vergleich zum Kompaktieren grundsätzlich unverändert und beläuft sich gleichfalls auf 0,5 mm bis 15 mm. Beim Schweißen wird auf die Leitungen ein Druck zwischen 1 bar und 6 bar ausgeübt. Die Energie, die dem Schwinger 117 zugeführt wird, liegt zwischen 50 Ws und 10 000 Ws. Die Gesamtschweißdauer beläuft sich zwischen 0,2 s und 2 s bei einer Schwingungsamplitude zwischen 15 µm und 30 µm. Diese Werte sind rein beispielhaft, ohne dass die Erfindung hierdurch eingeschränkt werden soll.

Schließlich erfolgt die Ermittlung des Schweißmaßes, indem die Breite b und Höhe h oder eine andere spezifische Größe des Verdichtungsraums 10 erfasst wird.

Gemäß der Erfindung erfolgt die Berechnung des Verdichtungsgrads V online, d. h. unmittelbar nach Abschluss des Schweißens, wobei aus dem ermittelten tatsächlichen Gesamtquerschnitt $A_{tats}$ und dem ermittelten Schweißmaß, d. h. der Höhe h und Breite b des Schweißknotens der Verdichtungsgrad ermittelt wird. Die Berechnung des Verdichtungsgrads V erfolgt gemäß der Erfindung unter Zugrundelegung an sich bekannter Formeln:

a) $V = [A_{tats}/ (b \cdot (h - PK)] \cdot 100$ in %
oder
b) $V = [b \cdot h/ A_{tats}] \cdot 100$ in %.

wobei das Ergebnis aus a) und b) nicht direkt vergleichbar ist, d.h., es gelten unterschiedliche Zielwerte. Gemäß der Erfindung wird die Formal a) bevorzugt.

In der Formel ist PK eine Größe, die die Geometrie bzw. Profilierung der Begrenzungsflächen 12 und 18 des Verdichtungsraums 10 berücksichtigt, also die der Sonotrode 20 und des die Kraft übertragenden Querhaupts 28 der Gegenelektrode 22. Der Faktor PK liegt üblicherweise im Bereich zwischen 0,1 und 0,5. Bevorzugterweise wird der Wert von etwa 0,2 zum Ansatz gebracht. b bedeutet die Breite und h die Höhe des Verdichtungsraums 10 nach Beendigung des Schweißvorganges, gibt folglich den Querschnitt des hergestellten Knotens wieder.

Bevorzugte Werkzeuggeometrien sind: Wellengeometrie mit angepasster Wellenhöhe, Wellenabstand, Wellenformen und Wellenzahl; Kreuzriffel mit Pyramiden oder Pyramidenstümpfen.

In bevorzugter Ausführungsform wird der Verdichtungsgrad V grafisch und numerisch nach jeder Schweißung angezeigt und kann gespeichert bzw. protokolliert werden.

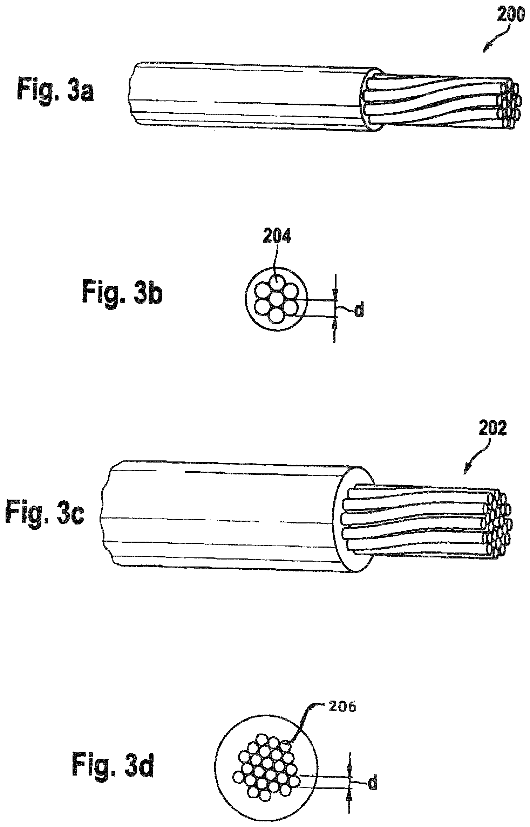

Die wesentlichen erfindungsgemäßen Merkmale sollen noch einmal anhand der Fig. 3 bis 8 verdeutlicht werden.

Den Fig. 3a) bis 3d) sind Abschnitte bzw. Querschnitte von Leitungen 200, 202 rein prinzipiell dargestellt. Die Leitung 200 weist einen symmetrischen Aufbau auf und besitzt z. B. einen Nominalquerschnitt von 0,50 mm². Die Anzahl der Adern 204 beträgt 7. Der Durchmesser jeder Ader 204 ist 0,29 mm. Somit ergibt sich rechnerisch ein tatsächlicher Gesamtquerschnitt von 0,46 mm², der von dem Nominalquerschnitt erkennbar abweicht.

Die Leitung 202 gemäß Fig. 3c) weist einen unsymmetrischen Aufbau mit insgesamt 24 Adern 206 auf. Der Durchmesser jeder Ader beträgt z. B. 0,19 mm, so dass sich ein tatsächlicher Gesamtquerschnitt von 0,68 mm² ergibt. Der Nominalquerschnitt wird jedoch mit 0,75 mm² angegeben.

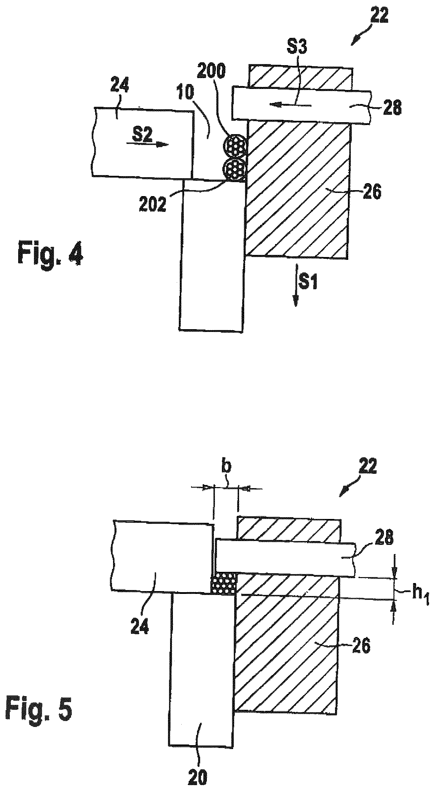

Die Ultraschallschweißanlage 110 ist üblicherweise derart vorprogrammiert, dass in dieser Kompaktier- und Schweißparameter für vorbekannte Leitungen abgespeichert sind. Der Bediener kennt den Nominalquerschnitt der zu einem Knoten zu verschweißenden Leitungen. Der Nominalquerschnitt ist dabei derjenige, der sich aus sämtlichen Leitungen ergibt. Um aus mehreren Leitungen einen Knoten zu schweißen, wird infolgedessen zunächst der Gesamtnominalquerschnitt in die Steuerung eingegeben. Auf deren Basis werden in der Steuerung abgelegte Kompaktierparameter abgerufen. Die Leitungen werden in den Verdichtungsraum 10 eingelegt, die Breite b des Verdichtungsraums eingestellt und sodann durch Absenken des Ambosses 22 das Kompaktieren durchgeführt, ohne dass die Breite b verändert wird. Dies soll anhand der Fig. 4 und 5 verdeutlicht werden. So werden zunächst die Leitungen 200, 202 in den Verdichtungsraum 10 eingelegt, um sodann den Schieber 24 auf einen vorgegebenen Wert einzustellen, um sodann das Querhaupt 28 der mehrteiligen Gegenelektrode 22 in Richtung des Schiebers 24 zu verstellen und den Amboss 22 in Pfeilrichtung S1 abzusenken. Als Kompaktierparameter werden Druck, Amplitude und Energie entsprechend dem vorbekannten Gesamtnominalquerschnitt automatisch eingestellt. Nach dem Kompaktieren weisen die Leitungen 200, 202 einen Kompaktierquerschnitt A1 auf, der durch die Breite b des Verdichtungsraums 10 und die Höhe h1 bestimmt wird.

Sodann werden in ein und derselben Ultraschallschweißvorrichtung Leitungen unterschiedlicher Gesamtnominalquerschnitte entsprechend zuvor beschriebener Verfahrensweise kompaktiert, um in Abhängigkeit von den verschiedenen Gesamtnominalquerschnitten entsprechende Kompaktierquerschnitte $A_1$ ... $A_n$ zu ermitteln.

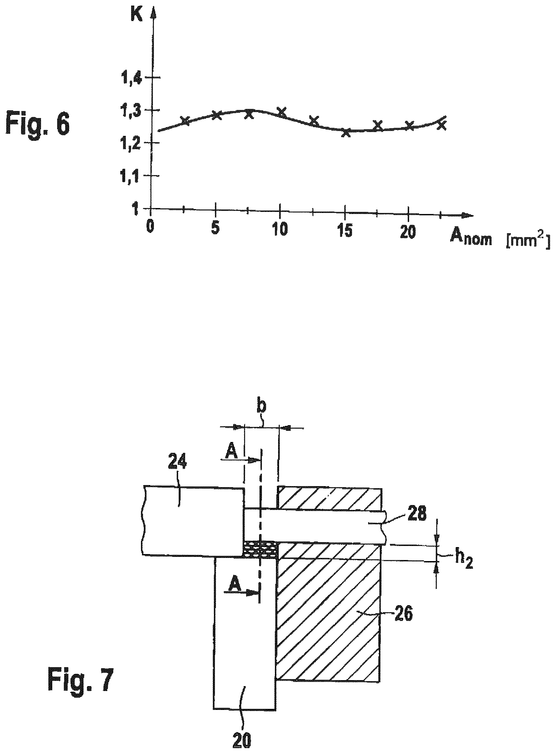

Sodann wird für jeden Gesamtnominalquerschnitt ein Korrekturwert K ermittelt, der sich aus dem Quotienten aus den Kompaktierquerschnitten $A_1$ ... $A_n$ der kompaktierten Leitungen und dem tatsächlichen Gesamtquerschnitt $A_{tats}$, ... $A_{tatsu}$ der jeweils zu verschweißenden Leitungen ergibt. Der jeweilige tatsächliche Gesamtquerschnitt $A_{tats}$ der Leitungen ist derjenige, der sich aus der Anzahl und den Durchmessern der Adern der Leitungen ergibt, die verschweißt werden sollen. Anschließend wird eine Korrelationsfunktion ermittelt, in der die dimensionslosen Korrekturwerte K gegenüber den Gesamtnominalquerschnitten $A_{nom}$ in mm² aufgetragen sind, wie diese beispielhaft in der Fig. 6 dargestellt ist. Somit kann man bei bekanntem Gesamtnominalquerschnitt und ermitteltem Kompaktierquerschnitt unmittelbar den tatsächlichen Gesamtquerschnitt $A_{tats}$ berechnen, da die entsprechende Korrelationsfunktion im Rechner der Ultraschallschweißanlage abgelegt ist. Die Korrelationsfunktion ergibt sich folglich aus den einzelnen Korrekturwerten K in Abhängigkeit von den Gesamtnominalquerschnitten $A_{nom}$.

Der tatsächliche Gesamtquerschnitt $A_{tats}$ ergibt sich gemäß der Erfindung folglich aus der Formel

$$A_{tats} = A : K$$

wobei K der aus der Korrelationsfunktion in Abhängigkeit von dem Gesamtnominalquerschnitt ermittelte Korrekturwert und A der Kompaktierquerschnitt für die Leitung mit dem Gesamtnominalquerschnitt ist.

Um nun den Verdichtungsgrad eines Knotens beim Einsatz einer entsprechenden Ultraschallschweißvorrichtung zu ermitteln, werden in zuvor beschriebener Weise zunächst in Abhängigkeit von dem bekannten Gesamtnominalquerschnitt die Kompaktierparameter automatisch eingestellt, um sodann nach Einlegen der Leitungen in den Verdichtungsraum 10 diese zu kompaktieren. Am Ende des Kompaktierens wird der Kompaktierquerschnitt A aus den Abmessungen des Verdichtungsraums 10 automatisch ermittelt, um somit unter Berücksichtigung der Korrelationsfunktion den tatsächlichen Gesamtquerschnitt $A_{tats}$ zu berechnen. Nach dem Kompaktieren wird das Schweißen durchgeführt. Die Schweißparameter werden entweder in Abhängigkeit von dem Gesamtnominalquerschnitt oder von dem tatsächlichen Gesamtquerschnitt abgerufen. Nach dem Schweißen wird aus der Geometrie des Verdichtungsraums automatisch das den Querschnitt des Knotens repräsentierende Schweißmaß ermittelt, um sodann unter Berücksichtigung des tatsächlichen Gesamtquerschnitts $A_{tats}$ den Verdichtungsgrad V online zu berechnen, der sodann grafisch und/oder numerisch auf einem Bildschirm der Ultraschallschweißvorrichtung angezeigt werden kann. Auch ein Speichern der Werte erfolgt.

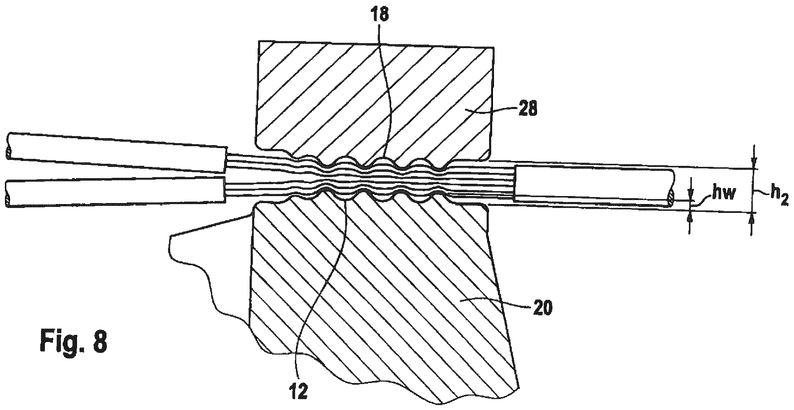

Bei der Ermittlung des Verdichtungsgrades kann auch die Profilierung der durch die Sonotrode 20 und die Gegenelektrode 22 bzw. des Querhaupts 28 gebildeten Begrenzungsflächen eingehen, wie dies anhand der Fig. 8 prinzipiell verdeutlicht werden soll. So geht entsprechend der zuvor wiedergegebenen Formel b) das Maß PK ein, das im Ausführungsbeispiel durch die Höhe hw der Profilierung der den Verdichtungsraum 10 begrenzenden Fläche der Sonotrode 10 oder des Ambosses 22 vorgeben wird. Der Korrekturfaktor PK dient zur Kompensation der Wellenstruktur. Die Größe hw hängt von den zum Einsatz gelangenden Werkzeugtypen ab. Die Profilkorrektur PK liegt üblicherweise zwischen 0,1 und 0,5, vorzugsweise im Bereich von 0,2.

**Patentansprüche**

1. Verfahren zur Ermittlung des Verdichtungsgrades V eines Knotens durch Kompaktieren und Schweißen von in einen in Höhe (h) und Breite (b) verstellbaren Verdichtungsraum (10) einer Ultraschallschweißanlage (110) eingelegten elektrischen Leitungen (200, 202) bekannten Gesamtnominalquerschnitts $A_{nom}$, die aus Adern (204, 206) mit einem tatsächlichen Gesamtquerschnitt $A_{tats}$ bestehen, wobei der Verdichtungsraum zumindest von einer Sonotrode (20), einer Gegenelektrode oder einem Amboss (22, 28) und einem eine begrenzende Fläche (14) aufweisenden Seitenschieber (24) begrenzt wird, umfassend die Verfahrensschritte:

    - Einlegen der Leitungen (200, 202) in den Verdichtungsraum (10),
    - Kompaktieren der Leitungen,
    - Ermitteln des Kompaktierquerschnitts A der kompaktierten Leitungen,

    **gekennzeichnet durch** die folgenden weiteren Schritte:

    - Ermitteln des tatsächlichen Gesamtquerschnitts $A_{tats}$ über eine den Kompaktierquerschnitt A berücksichtigende Korrelationsfunktion mit $A_{tats} = A : K$. wobei K ein aus der Korrelationsfunktion in Abhängigkeit von dem Gesamtnominalquerschnitt ermittelter Korrekturwert ist,
    - Schweißen des kompaktierten Knotens mit einem Schweißparametersatz unter Zugrundelegung des Gesamtnominalquerschnitts $A_{nom}$ oder des tatsächlichen Gesamtquerschnitts $A_{tats}$,
    - Ermitteln eines Schweißmaßes aus Höhe (h) und Breite (b) des Verdichtungsraums (10) nach dem Schweißen,
    - Berechnung des Verdichtungsgrades unter Zugrundelegung des tatsächlichen Gesamtquerschnitts $A_{tats}$ und des Schweißmaßes unter Berücksichtigung einer der Gleichungen

        a) $V = [A_{tats}/ b \cdot (h - PK)] \cdot 100$ in %
        b) $V = [b \cdot h/ A_{tats}] \cdot 100$ in %,

    wobei PK Geometrie bzw. Profilierung der den Verdichtungsraum begrenzenden Flächen (12, 18) der Sonotrode (20) und der Gegenelektrode (22, 28) berücksichtigt.

2. Verfahren nach Anspruch 1.
    **dadurch gekennzeichnet,**
    **dass** Leitungen (200, 202) mit voneinander abweichenden zuvor ermittelten tatsächlichen Gesamtquerschnitten kompaktiert werden und der Quotient von jedem tatsächlichen Gesamtquerschnitt und zugehörigem Kompaktierquerschnitt gebildet wird und dass durch Auftragen des Quotienten gegenüber dem dem tatsächlichen Gesamtquerschnitt zugeordneten Gesamtnominalquerschnitt die Korrelationsfunktion gebildet wird.

3. Verfahren nach Anspruch 1 oder 2,
**dadurch gekennzeichnet,**
**dass** bei der Berechnung des Verdichtungsgrades Profilgeometrien der den Verdichtungsraum begrenzenden Sonotroden- und Gegenelektrodenflächen (12, 18) der Ultraschallschweißanlage (110) berücksichtigt werden.

4. Verfahren nach einem der vorhergehenden Ansprüche,
**dadurch gekennzeichnet,**
**dass** das Kompaktieren der Leitungen (200, 202) mit Kompaktierparametern auf der Basis des Gesamtnominalquerschnitts durchgeführt wird.

5. Verfahren nach einem der vorhergehenden Ansprüche,
**dadurch gekennzeichnet,**
**dass** als Schweiß- und/oder Kompaktierparameter in die Leitungen (200, 202) eingeleiteter Druck und/oder Ultraschallamplitude und/oder Ultraschallenergie verwendet werden.

6. Verfahren nach einem der vorhergehenden Ansprüche,
**dadurch gekennzeichnet,**
**dass** der Verdichtungsgrad grafisch und/oder numerisch dargestellt wird.

**Claims**

1. A method for determining the compression level V of a node by compacting and welding electrical lines (200, 202) inserted into a compression chamber (10) of an ultrasonic welding system (110), which compression chamber can be adjusted in height (h) and width (b), these electrical lines have a known total nominal cross section $A_{nom}$ and consist of wires (204, 206) with an actual total cross section $A_{act}$, wherein the compression chamber (10) is limited at least by a sonotrode (20), a counterelectrode or an anvil (22, 28) and a lateral glider (24) having a delimiting surface (14),
comprising the steps:

- Placind the lines (200, 202) into the compression chamber (10),
- Compacting the lines,
- Determining the cross section of compaction A of the compacted lines, **characterized by** the method steps:
- Determining the actual cross section $A_{act}$ with a correlation function that takes into account the compacting cross section A, with $A_{act}$ = A : K, in which K is the correction value determined from the correlation function as a function of the nominal cross section,
- Welding the compacted node with a set of welding parameters, taking as base the total nominal cross section $A_{nom}$ or the actual total cross section $A_{act}$,
- Determining a welding dimension from the height (h) and width (b) of the compression chamber (10) after the welding,
- Calculating the compression level taking as base the actual cross section $A_{act}$ and the welding dimension and calculation of the compression level V based on the formulas:

a) V = [$A_{act}$ / b • (h - PK)] • 100 in %
b) V = [b • h / $A_{act}$] • 100 in %,

wherein PK is a magnitude, that take into amount the geometry or profiling of the delimiting surfaces (12, 18) of the sonotrode (20) and the counterelectrode (22, 28).

2. The method according to claim 1,
**characterized in that**
lines (200, 202) with actual cross sections that differ from each other and were previously determined are compacted and that the quotient of each total cross section and the associated compacting cross section is formed and that the correlation function is formed by plotting the quotient opposite the total nominal cross section associated with the actual total cross section.

3. The method according to claim 1 or 2,
**characterized in that**
in the calculation of the compression level profile geometries of the sonotrodes surfaces and counterelectrode surfaces (12, 18) of the ultrasonic welding system (110) which delimit the compression chamber are taken into account.

4. The method according to at least one of the previous claims,
**characterized in that**
the compacting of the lines (200, 202) is carried out with compacting parameters based on the total nominal cross section.

5. The method according to at least one of the previous claims,
**characterized in that**
pressure introduced into the lines (200, 202) and/or ultrasonic amplitude and/or ultrasonic energy are used as welding and/or compacting parameters.

6. The method according to at least one of the previous claims,
   **characterized in that**
   the compression level is displayed graphically and/or numerally.


**Revendications**

1. Procédé pour déterminer le degré de compression V d'un noeud obtenu par compactage et soudage de câbles électriques (200, 202) placés dans une chambre de compression (10) réglable en hauteur (h) et en largeur (b) d'une installation de soudage par ultrasons (110), de section nominale totale $A_{nom}$ connue, lesquels câbles électriques sont constitués de fils (204, 206) avec une section totale réelle $A_{réel}$, sachant que la chambre de compression est délimitée par au moins une sonotrode (20), une contre-électrode ou une enclume (22, 28) et un coulisseau latéral (24) présentant une surface de délimitation (14), comprenant les étapes de procédé suivantes :

   - positionnement des câbles (200, 202) dans la chambre de compression (10),
   - compactage des câbles,
   - détermination de la section de compactage A des câbles compactés, **caractérisé par** les autres étapes suivantes :
   - détermination de la section totale réelle $A_{réel}$ au moyen d'une fonction de corrélation tenant compte de la section de compactage A, telle que $A_{réel}$ = A : K, sachant que K est une valeur de correction déterminée à partir de la fonction de corrélation, en fonction de la section nominale totale,
   - soudage du noeud compacté avec un jeu de paramètres de soudage sur la base de la section nominale totale $A_{nom}$ ou de la section totale réelle $A_{réel}$,
   - détermination d'une cote de soudage à partir de la hauteur (h) et de la largeur (b) de la chambre de compression (10) après le soudage,
   - calcul du degré de compression sur la base de la section totale réelle $A_{réel}$ et de la cote de soudage en tenant compte d'une des équations

     **a)** $V = [A_{réel} / b \cdot (h - PK)] \cdot 100$ en %
     **b)** $V = [b \cdot h / A_{réel}] \cdot 100$ en %,

   sachant que PK tient compte de la géométrie ou du profilage des surfaces (12, 18) de la sonotrode (20) et de la contre-électrode (22, 28), délimitant la chambre de compression.

2. Procédé selon la revendication 1,
   **caractérisé en ce**
   **que** les câbles (200, 202) sont compactés avec des sections totales réelles calculées préalablement et divergeant les unes des autres et que le quotient de chaque section totale réelle et de la section de compactage associée est formé et que la fonction de corrélation est formée en représentant le quotient par rapport à la section nominale totale attribuée à la section totale réelle.

3. Procédé selon la revendication 1 ou 2,
   **caractérisé en ce**
   **que** les géométries des profils des surfaces de la sonotrode et de la contre-électrode (12, 18) de l'installation de soudage par ultrasons (110), délimitant la chambre de compression sont prises en compte lors du calcul du degré de compression.

4. Procédé selon une des revendications précédentes,
   **caractérisé en ce**
   **que** le compactage des câbles (200, 202) est réalisé avec des paramètres de compactage sur la base de la section nominale totale.

5. Procédé selon une des revendications précédentes,
   **caractérisé en ce**
   **que** sont utilisés comme paramètres de soudage et/ou de compactage la pression appliquée aux câbles (200, 202) et/ou l'amplitude des ultrasons et/ou l'énergie ultrasonique.

6. Procédé selon une des revendications précédentes,
   **caractérisé en ce**
   **que** le degré de compression est représenté graphiquement et/ou numériquement.

Fig. 1

EP 2 996 834 B1

# Fig. 2

Fig. 3a

200

Fig. 3b

204

d

Fig. 3c

202

Fig. 3d

206

d

22

S3

24    200

10

28

S2

26

202

S1

## Fig. 4

b

22

28

24

h₁

26

20

## Fig. 5

13

**Fig. 6**

**Fig. 7**

Fig. 8

EP 2 996 834 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 4429684 A1
- EP 701876 A1
- DE 4335108 C1
- WO 9109704 A1
- EP 0421018 A1